# EUROPÄISCHE PATENTANMELDUNG

(11) **EP 4 134 268 A1**
(43) Veröffentlichungstag der Anmeldung: **15.02.2023**
(21) Anmeldenummer: 22188857.1
(22) Anmeldetag: 04.08.2022
(51) Int. Cl.: B60L 58/12, B60L 58/24

(54) **VORRICHTUNG, SYSTEM UND VERFAHREN ZUM ÜBERWACHEN EINES PARAMETERS EINES FAHRZEUGS**

(30) Priorität: 10.08.2021 DE 102021120809
(71) Anmelder: OptiMEAS Measurement and Automation Systems GmbH, 61381 Friedrichsdorf (DE)
(72) Erfinder: Kessel, Jens-Achim, 64807 Dieburg (DE); Schranz, Burkhard, 8477 Oberstammheim (CH); Langfeld, Patrick, 76149 Karlsruhe (DE)
(74) Vertreter: Patentanwälte Bauer Vorberg Kayser

(57) **Zusammenfassung**

Es ist eine Vorrichtung (1) zum Überwachen eines Parameters eines Fahrzeugs, vorzugsweise eines Schienenfahrzeugs, offenbart. Diese Vorrichtung (1) umfasst ein Primärmodul (2) und ein Sekundärmodul (3), wobei das Sekundärmodul (3) über mindestens eine Schnittstelle (4) mit dem Primärmodul (2) verbunden und durch das Primärmodul (2) zumindest teilweise steuerbar ist. Das Primärmodul (2) umfasst:
einen Energieversorgungseingang (5), der zum Eingeben einer Versorgungsspannung (Uv) aus einer Energieversorgung (6) des Fahrzeugs in das Primärmodul (2) ausgebildet ist,
ein Erfassungsmodul (11), das zum Erfassen mindestens einer Messgröße und zum Ermitteln eines ermittelten Parameters bezüglich des Fahrzeugs aus der mindestens einen Messgröße ausgebildet ist,
eine Aktivierungsschaltung (9), die dazu ausgebildet ist, unter Nutzung des ermittelten Parameters das Sekundärmodul (3) zu aktivieren und/oder zu steuern, und
einen Signalisierungsausgang (16), der dazu ausgebildet ist, basierend auf dem ermittelten Parameter eine Signalisierung zu erzeugen und/oder auszugeben.

Ferner ist ein System mit einer derartigen Vorrichtung und mindestens einer Datenquelle und/oder mindestens einer Datensenke offenbart.

Ferner ist ein entsprechendes Verfahren offenbart.

## Beschreibung

Die Erfindung betrifft eine Vorrichtung, ein System sowie ein Verfahren zum Überwachen eines Parameters eines Fahrzeugs, vorzugsweise eines Schienenfahrzeugs. Ferner betrifft die Erfindung ein Fahrzeug, vorzugsweise ein Schienenfahrzeug, das mit einer derartigen Vorrichtung bzw. einem derartigen System ausgestattet ist.

Bei Fahrzeugen tritt immer wieder der Bedarf auf, dass ein oder mehrere Parameter des Fahrzeugs überwacht werden müssen und gegebenenfalls geeignet auf den/die ermittelten Parameter reagiert werden muss. Derartige Parameter können beispielsweise einen Ladezustand einer Batterie, einen Füllstand eines Tanks, Druckbehälters oder sonstigen Treibstoffbehälters, eine Temperatur, einen geografischen Ort, einen Betriebszustand des Fahrzeugs oder dergleichen umfassen. Bei Fahrzeugen, die durch eine oder wenige Personen genutzt werden und/oder deren Standort regelmäßig bekannt ist, ist dieses Erfordernis meist problemlos erfüllbar, da im Bedarfsfall das Fahrzeug aufgesucht, die Information ausgelesen und geeignet auf eine ausgelesene Information reagiert werden kann. Bei Fahrzeugen, die beispielsweise von mehreren Personen genutzt, über längere Zeit abgestellt oder in einem großen geografischen Gebiet eingesetzt werden, ist das Beschaffen derartiger Informationen häufig problematisch. Derartige Fahrzeuge sind beispielsweise Schienenfahrzeuge, wie Lokomotiven, Triebwagen, Waggons, Steuerwagen, Züge oder dergleichen. Ferner sind auch Parameter denkbar, für die eine personengebundene Überwachung nicht praktikabel ist, beispielsweise bei Parametern, die sich in kürzerer Zeit ändern, wie eine Temperatur. Hier sind Lösungen gefragt, mit denen Parameter des Fahrzeugs überwacht und bedarfsgerecht verarbeitet werden können.

Für einige der genannten Parameter sind aus der Praxis Vorrichtungen bekannt, die Ansätze von Überwachungsmöglichkeiten bieten. So sind Spannungsüberwachungsrelais bekannt, wie beispielsweise das Sirius 3UG4 von Siemens, mit denen bei Unter- oder Überschreiten einer Spannungsschwelle ein verbundenes Gerät abgeschaltet werden kann. Damit kann beispielsweise bei einer Fahrzeugbatterie der Zustand "Überspannung" oder "Unterspannung" erkannt und geeignet reagiert werden. Nachteilig dabei ist, dass nach einer Abschaltung ein Rücksetzen von außen veranlasst werden muss, z.B. durch Herstellen einer validen Betriebsspannung.

Im praktischen Einsatz sind bei derartigen Vorrichtungen häufig umfangreiche externe Beschaltungen erforderlich, um gewünschte Funktionalitäten zu ermöglichen. Zu der externen Beschaltung kann eine Schaltung zur Anpassung eines zu geringen Eingangsspannungsbereichs oder eine Schaltung zum Erhöhen einer schaltbaren Leistung gehören. Die externe Beschaltung kann aber auch Einheiten umfassen, die ein Wiedereinschalten der Vorrichtung, ein zeitgesteuertes Einschalten der Vorrichtung, ein kontinuierliches Aufzeichnen von Messwerten und/oder ein Kommunizieren eines überwachten Parameters nach außen ermöglichen. Dadurch entstehen jedoch komplexe Gesamtsysteme.

Weiter problematisch ist, dass derartige Vorrichtungen und Systeme meist einen nicht unerheblichen Energieverbrauch haben. Wenn ermittelte Parameter über ein Weitbereichsnetzwerk, beispielsweise ein Mobilfunknetzwerk, kommuniziert werden sollen, steigt der Energieverbrauch noch weiter. Da die meisten Fahrzeuge nicht fest mit einem Energieversorgungsnetzwerk verbunden sind, ist die verfügbare elektrische Energie begrenzt. Insbesondere bei Schienenfahrzeugen im abgerüsteten Zustand, d.h. bei abgestellten Schienenfahrzeugen, die von einem Energieversorgungsnetzwerk getrennt sind und/oder deren Antriebsaggregat abgeschaltet ist, erfolgt eine Versorgung der Vorrichtung aus einem elektrischen Energiespeicher, meist einer Batterie oder einem System von Batterien. Daher kann der Energiebedarf des Überwachungssystems zu kritischen Zuständen führen. Wenn der elektrische Energiespeicher zu weit entladen ist, kann das Schienenfahrzeug nicht mehr gestartet werden. Es muss zu der nächsten Lademöglichkeit geschleppt werden, was mit einem erheblichen Aufwand verbunden ist. Die verfügbare elektrische Energie kann zudem durch ungünstige Temperaturen beeinflusst sein, da sich beispielsweise kalte Batterien schneller entladen oder zu warme Batterien eine reduzierte Effizienz haben.

Insbesondere bei Schienenfahrzeugen kommt ergänzend hinzu, dass die dort eingesetzten Vorrichtungen üblicherweise für den Schieneneinsatz zertifiziert sein müssen. Daher sind viele Systeme, bei denen beispielsweise ein Energiemanagement integriert ist, nicht oder nur mit großem Aufwand einsetzbar. Denn jeder Zustand der Vorrichtung muss separat zertifiziert werden, was eine Zertifizierung meist sehr umfangreich macht.

Der vorliegenden Erfindung liegt die Aufgabe zugrunde, eine Vorrichtung ein System, ein Fahrzeug und ein Verfahren der eingangs genannten Art derart auszugestalten und weiterzubilden, dass eine möglichst energieeffiziente und dennoch möglichst flexible Überwachung mindestens eines Parameters eines Fahrzeugs möglich ist.

Gemäß einer Ausgestaltung wird die voranstehende Aufgabe durch die Merkmale des Anspruchs 1 gelöst. Danach umfasst die in Rede stehende Vorrichtung ein Primärmodul und ein Sekundärmodul, wobei das Sekundärmodul über mindestens eine Schnittstelle mit dem Primärmodul verbunden und durch das Primärmodul zumindest teilweise steuerbar ist, wobei das Primärmodul zumindest umfasst:
einen Energieversorgungseingang, der zum Eingeben einer Versorgungsspannung aus einer Energieversorgung des Fahrzeugs in das Primärmodul ausgebildet ist,
ein Erfassungsmodul, das zum Erfassen mindestens einer Messgröße und zum Ermitteln eines ermittelten Parameters bezüglich des Fahrzeugs aus der mindestens einen Messgröße ausgebildet ist,
eine Aktivierungsschaltung, die dazu ausgebildet ist, unter Nutzung des ermittelten Parameters das Sekundärmodul zu aktivieren und/oder zu steuern, und
einen Signalisierungsausgang, der dazu ausgebildet ist, basierend auf dem ermittelten Parameter eine Signalisierung zu erzeugen und/oder auszugeben.

Bezüglich eines Systems ist die voranstehende Aufgabe durch die Merkmale des nebengeordneten Anspruchs 12 gelöst. Danach umfasst das in Rede stehende System:
eine Vorrichtung gemäß der vorliegenden Offenbarung und
mindestens eine Datenquelle und/oder mindestens eine Datensenke,
wobei die mindestens eine Datenquelle / mindestens eine Datensenke vorzugsweise einen Datenlogger, ein Datenspeichergerät, ein Kommunikationsgerät für ein Weitbereichsnetzwerk, einen Sensor, ein Ein-/Ausgabegerät zum Ansteuern eines Sensors, einen Empfänger für Signale aus einem Positionsbestimmungssystem und/oder ein Steuergerät umfasst.

Bezüglich eines Fahrzeugs ist die voranstehende Aufgabe durch die Merkmale des ebenfalls nebengeordneten Anspruchs 14 gelöst. Danach umfasst das in Rede stehende Fahrzeug eine Vorrichtung und/oder ein System gemäß der vorliegenden Offenbarung sowie eine Energieversorgung, die mit dem Energieversorgungseingang der Vorrichtung verbunden ist.

Bezüglich eines Verfahrens ist die voranstehende Aufgabe durch die Merkmale des weiter nebengeordneten Anspruchs 15 gelöst. Danach ist das Verfahren zur Verwendung mit einer Vorrichtung bzw. einem System gemäß der vorliegenden Offenbarung ausgestaltet und umfasst die Schritte:
Erfassen mindestens einer Messgröße, wobei die mindestens eine Messgröße eine physikalische Größe bezüglich des Fahrzeugs repräsentiert,
Ermitteln eines ermittelten Parameters bezüglich des Fahrzeugs basierend auf der mindestens einen Messgröße und
bedarfsgerechtes Aktivieren/Deaktivieren des Sekundärmoduls der Vorrichtung und/oder Erzeugen und/oder Ausgeben einer Signalisierung basierend auf dem ermittelten Parameter.

Es ist erkannt worden, dass eine energieeffiziente Überwachung eines Parameters eines Fahrzeugs durch eine flexible Steuerbarkeit der Vorrichtung erzielbar ist. Auf diese Weise lassen sich Funktionseinheiten der Vorrichtung bedarfsgerecht und gezielt aktivieren und deaktivieren, wodurch eine optimierte Nutzung der verfügbaren elektrischen Energie ermöglicht wird. Diese flexible Steuerbarkeit wird gemäß der vorliegenden Offenbarung durch die Verwendung eines Primärmoduls und eines Sekundärmoduls erreicht, wobei das Sekundärmodul über mindestens eine Schnittstelle mit dem Primärmodul verbunden und durch das Primärmodul zumindest teilweise steuerbar ist.

Dabei kann es vorteilhaft sein, wenn das Primärmodul Basisfunktionalitäten der Vorrichtung bereitstellt und sich des Sekundärmoduls für weiterreichende Funktionalitäten bedient. Je einfacher diese Basisfunktionalitäten ausgestaltet sind, desto effizienter kann das Primärmodul - in vielen Einsatzszenarien - betrieben werden. Da die weiterreichenden Funktionalitäten meist ressourcen- und energieaufwändig sind, kann eine Ressource durch das Primärmodul dann aktiviert werden, wenn sie auch wirklich benötigt wird und/oder wenn zumindest ausreichend Energie für den Betrieb dieser Ressource bereitgestellt werden kann. Auf diese Weise lässt sich eine Energieoptimierung erreichen.

Dieses Konzept bietet insbesondere bei dem Einsatz in Schienenfahrzeugen einen weiteren Vorteil, dass nämlich das Primärmodul für eine Zertifizierung optimierbar ist, während das Sekundärmodul von dem Fahrzeug gekapselt werden kann. Dadurch kann eine nachvollziehbare Rückwirkung der Vorrichtung auf das Fahrzeug, idealerweise eine Rückwirkungsfreiheit, erreicht werden. Hierzu kann es sich anbieten, wenn das Primärmodul recht "starr" aufgebaut ist, d.h. wenn die Funktionalität und Arbeitsweise des Primärmoduls bei dessen Herstellung festgelegt sind und im Nachhinein nicht mehr (oder nur in sehr engen Grenzen) änderbar ist. Dies kann beispielsweise durch Nutzung eines fest programmierten Mikrocontrollers erreicht werden. Dieser zunächst widersinnig erscheinende Ansatz, nämlich eine Flexibilisierung der Vorrichtung durch ein "starres" Primärmodul, kann bei der vorliegenden Offenbarung durch das Zusammenspiel mit einem Sekundärmodul ein großes Potential entfalten.

Das Primärmodul kann einen Energieversorgungseingang, ein Erfassungsmodul, eine Aktivierungsschaltung und einen Signalisierungsausgang aufweisen. Der Energieversorgungseingang kann zum Eingeben einer Versorgungsspannung aus einer Energieversorgung des Fahrzeugs in das Primärmodul ausgestaltet sein. Auf diese Weise lässt sich an einer definierten Stelle elektrische Energie in das Primärmodul eingeben. Das Erfassungsmodul kann zum Erfassen mindestens einer Messgröße und zum Ermitteln eines ermittelten Parameters bezüglich des Fahrzeugs ausgebildet sein. Dabei wird der ermittelte Parameter basierend auf einer erfassten Messgröße ermittelt. Damit lassen sich wichtige Messgrößen und/oder Parameter durch das Primärmodul erfassen, wodurch eine Unabhängigkeit von dem Zustand des Sekundärmoduls entsteht. Dies bedeutet beispielsweise, dass eine Messgröße auch in einem Energiesparmodus gezielt erfasst, ausgewertet und/oder gespeichert werden kann, ohne dass ein Sekundärmodul aktiviert sein muss. Die Aktivierungsschaltung kann zum Aktivieren und/oder Steuern des Sekundärmoduls ausgebildet sein, wobei hierbei der ermittelte Parameter genutzt werden kann. Der Signalisierungsausgang kann zum Erzeugen und/oder Ausgeben einer Signalisierung basierend auf dem ermittelten Parameter ausgebildet sein. Auf diese Weise kann das Primärmodul flexibel auf einen ermittelten Parameter reagieren und bedarfsgerecht erforderliche Schritte initiieren.

Die Vorrichtung der vorliegenden Offenbarung kann auf verschiedene Weise implementiert sein. Eine Implementierung in Hardware ist ebenso denkbar wie eine Implementierung in Software. In einer bevorzugten Ausgestaltung ist die Vorrichtung als Kombination aus Hardware und Software implementiert. Dabei kann ein Mikroprozessor, ein Mikrocontroller und/oder ein anderer programmierbarer Logikbaustein (FPGA, CPLD, ...) zum Einsatz kommen.

Es bietet sich an, dass das Primärmodul und das Sekundärmodul durch dedizierte Module implementiert sind, die über definierte Schnittstellen miteinander verbunden sind. Üblicherweise dürfte dies bei einer Implementierung durch Soft- und Hardware bedeuten, dass das Primärmodul und das Sekundärmodul getrennte Hardware-Komponenten aufweisen. So kann das Primärmodul einen Mikroprozessor, beispielsweise einen Mikrocontroller, und das Sekundärmodul einen separaten Mikroprozessor aufweisen. Dabei können Primär- und Sekundärmodul auf separaten Platinen ausgebildet sein. Es ist aber auch denkbar, dass die Module auf einer gemeinsamen Platine angeordnet sind, wobei die Module keine Bauteile (oder allenfalls wenige Bausteine, wie Optokoppler oder andere Schnittstellenbausteine) gemeinsam nutzen. Dedizierte Schnittstellen können durch definierte Verbindungen (beispielsweise elektrische oder optische Verbindungen) gebildet sein.

Die Vorrichtung umfasst ein Primärmodul, das ein oder mehrere Sekundärmodule aktivieren und/oder steuern kann. In einer Ausgestaltung sind das Primärmodul und das/die Sekundärmodul/e dabei in einer gemeinsamen Einheit implementiert. Dies kann bedeuten, dass das Primärmodul und das Sekundärmodul/die Sekundärmodule in einem gemeinsamen Gehäuse untergebracht sind. Eine derartige Ausgestaltung reduziert Fehleranfälligkeiten, da die Verbindungen zwischen den Modulen "von außen" nicht zugänglich sind und damit auch eine versehentliche Trennung nahezu ausgeschlossen werden kann.

Der Energieversorgungseingang kann auf verschiedene Weise ausgebildet sein. Dabei dürfte der Energieversorgungseingang (und eventuell die dem Energieversorgungseingang zurechenbaren Bauteile, wie beispielsweise eine Sicherung oder ein Verpolungsschutz) auf eine zu erwartende Versorgungsspannung angepasst sein. Diese Versorgungsspannung kann eine Gleichspannung oder eine Wechselspannung sein. Auch können unterschiedliche Spannungsniveaus und unterschiedlich breite Spannungsbereiche einer zulässigen Eingangsspannung zum Einsatz kommen. Da die Vorrichtung in einem Fahrzeug, vorzugsweise einem Schienenfahrzeug, zum Einsatz kommt, ist die Versorgungsspannung vorzugsweise durch eine Gleichspannung gebildet. Dabei können in einer Ausgestaltung Spannungen zwischen 15 V und 160 V, vorzugsweise zwischen 24 V und 110 V, verwendet werden, die sich beispielsweise durch Reihenschaltung mehrerer Batterien aufsummieren.

Auch das Erfassungsmodul kann verschiedentlich ausgestaltet sein. Wesentlich ist, dass das Erfassungsmodul mindestens eine Messgröße erfassen und einen ermittelten Parameter damit bestimmen kann. Dazu kann das Erfassungsmodul einen Sensor aufweisen, der die Messgröße erfasst und in ein Sensorsignal wandelt. In dieser Ausgestaltung wird das Erfassungsmodul meist noch einen Analog-Digital-Wandler aufweisen, der ein analoges Sensorsignal in ein digitalisiertes Signal umwandelt. Das Erfassungsmodul kann aber auch Zugriff auf einen Sensor haben, der nicht zu dem Erfassungsmodul selbst gehört und relativ zu dem Erfassungsmodul als "extern" bezeichnet werden könnte. In dieser Ausgestaltung kann das Erfassungsmodul ein Sensorsignal oder ein aufbereitetes Signal, beispielsweise ein digitalisiertes Signal oder ein Puls-Weiten-Moduliertes Signal, erhalten, in dem eine Messgröße kodiert ist.

Der mithilfe der erfassten Messgröße ermittelte Parameter kann ebenso verschiedentlich ausgebildet sein. In einer besonders einfachen Ausgestaltung kann der Parameter eine Repräsentation der Messgröße sein, beispielsweise ein Digitalwert. Ein Mehrwert kann der ermittelte Parameter insbesondere dann bieten, wenn der Parameter eine Bewertung der Messgröße wiedergibt. Diese Bewertung kann beispielsweise ein Vergleichsergebnis mit einem Sollwert oder einem Grenzwert sein, wobei der Parameter dann beispielsweise angeben kann, ob ein Sollwert erreicht wird, ob ein Grenzwert überschritten oder unterschritten ist oder ob eine Messgröße in einem vorgegebenen Bereich liegt. Diese Bewertung kann aber auch eine Relation zu einem Maximalbereich angeben, beispielsweise einen Prozentwert bezogen auf einen maximalen Messbereich. Diese kurze, nicht abschließende Aufzählung zeigt, wie flexibel ein ermittelter Parameter gebildet sein kann.

Auch die Aktivierungsschaltung kann unterschiedlich aufgebaut sein und auf das Sekundärmodul wirken. Wichtig ist, dass die Aktivierungsschaltung derart auf das Sekundärmodul einwirken kann, dass das Sekundärmodul aktiviert bzw. gesteuert werden kann. Dies kann durch Ausgeben eines Aufwecksignals an das Sekundärmodul verwirklicht sein, wobei das Aufwecksignal das Sekundärmodul in einen aktiven Zustand versetzt, beispielsweise aus einem Energiesparzustand. Die Aktivierungsschaltung kann aber auch eine Energieversorgung an das Sekundärmodul schalten. Die Aktivierungsschaltung kann auch das Sekundärmodul dadurch aktivieren bzw. steuern, dass eine Erfassung eines Messwerts durch das Sekundärmodul angestoßen wird. Auch diese kurze und nicht abschließende Auflistung zeigt, wie unterschiedlich die Aktivierungsschaltung prinzipiell auf ein Sekundärmodul einwirken kann.

Der Signalisierungsausgang sollte eine Signalisierung erzeugen und/oder ausgeben können, die auf dem ermittelten Parameter basiert. Wie konkret der Signalisierungsausgang und die dort erzeugte und ausgegebene Signalisierung ausgestaltet ist, hängt von der Art und Weise ab, wie eine Signalisierung in dem umgebenden System genutzt werden soll. Eine Signalisierung kann optisch und/oder akustisch erfolgen, indem im Bedarfsfall beispielsweise eine Leuchte oder ein Schallgenerator angeschaltet wird. In einer Ausgestaltung besteht eine Signalisierung in einer Nachricht, vorzugsweise einer digitalen Nachricht, in der der ermittelte Parameter kodiert ist oder die auf sonstige Weise auf dem ermittelten Parameter beruht. Diese Nachricht kann aus der Vorrichtung nach außen kommuniziert werden, beispielsweise in ein Cloud-System oder an ein Managementsystem. Hierbei kann ein Weitbereichsnetzwerk genutzt werden, wie beispielsweise ein Mobilfunknetz. Auf diese Weise kann auf eine ausgegebene Signalisierung auch aus größerer Entfernung von der Vorrichtung bzw. dem Fahrzeug reagiert werden, was die Überwachungsmöglichkeiten erheblich verbessert. Gleichzeitig kann dadurch ein System geschaffen werden, das vorausschauende Wartungen (Predictive Maintainance) ermöglicht.

In einer Ausgestaltung weist das Primärmodul eine Triggereinheit auf, wobei die Triggereinheit dazu ausgebildet ist, basierend auf einem Triggerereignis das Primärmodul vorzugsweise unabhängig von einem aktuellen Betriebsmodus der Vorrichtung zum Erfassen der mindestens einen Messgröße und/oder zum Ermitteln des ermittelten Parameters und/oder zum Erzeugen einer Signalisierung und/oder zum Ausgeben einer Signalisierung zu veranlassen. Auf diese Weise kann das Primärmodul abhängig von einem Triggerereignis betrieben werden. Dazu sollte die Triggereinheit in der Lage sein, ein Triggerereignis zu empfangen und eine Aktion, die mit dem Triggerereignis verknüpft oder verknüpfbar ist, auszulösen. Damit können beispielsweise zustands- und/oder zeitabhängig eine Messgröße erfasst und/oder ein Parameter ermittelt werden. In einer Weiterbildung kann diese Funktionalität dazu genutzt werden, selbst in dem Primärmodul einzelne Bestandteile zu deaktivieren, die bei einem Triggerereignis aktiv werden. Ferner kann noch gezielter auf Zustände und Ereignisse innerhalb des Fahrzeugs reagiert werden. Dabei kann ein Triggerereignis unterschiedlich ausgelöst sein und unterschiedliches bedeuten. Ein Triggerereignis kann innerhalb des Primärmoduls erzeugt oder durch eine Schnittstelle in das Primärmodul eingegeben worden sein. Solange der Triggereinheit bekannt ist, was ein Triggerereignis konkret besagt und wie auf ein Triggerereignis reagiert werden soll, ist ein entsprechendes Triggerereignis in der Vorrichtung gemäß der vorliegenden Offenbarung nutzbar.

In einer Weiterbildung umfasst die Vorrichtung einen Timer und/oder einen Triggereingang und/oder eine Bewertungseinheit, die dazu ausgebildet sind, ein Triggerereignis für die Triggereinheit zu erzeugen. Wenn die Vorrichtung einen Timer umfasst, kann der Timer abhängig von einer Zeit oder einer Zeitspanne ein Triggerereignis ausgeben. Der Timer kann auf diese Weise beispielsweise das Erfassen einer Messgröße nach Ablauf einer vordefinierten Zeitspanne, beispielsweise nach einer oder weniger Sekunden, nach einer oder mehreren Minuten oder nach einer oder mehreren Stunden, auslösen. Der Timer kann auch ein (Re-)Aktivieren des Primärmoduls insgesamt veranlassen, wodurch das Primärmodul nach Durchführen der gewünschten Aktivitäten nicht benötigte Teile abschalten und damit den Energiebedarf noch weiter reduzieren kann. Wenn die Vorrichtung einen Triggereingang umfasst, kann der Triggereingang zum Eingeben eines Zündsignals des Fahrzeugs ausgebildet sein. Ein Zündsignal gibt allgemein an, dass das Fahrzeug gestartet werden soll. Bei einem Fahrzeug mit Verbrennungsmotor bedeutet dies, dass der Verbrennungsmotor gestartet wird. Bei einem Fahrzeug mit Elektromotor kann das Zündsignal das Aktivieren einer Motorelektronik einleiten, die den Elektromotor geeignet ansteuern soll. Gemäß DIN 72552 wird das Zündsignal über die Klemme 15 (KL15) übertragen, um lediglich ein gebräuchliches Zündsignal zu nennen. Wenn die Vorrichtung eine Bewertungseinheit umfasst, kann die Bewertungseinheit zum Bewerten eines ermittelten Parameters ausgebildet sein. Auf diese Weise kann abhängig von einem Ergebnis des Bewertens eine Aktion ausgelöst werden. Diese Ausgestaltung bietet sich insbesondere dann an, wenn der Parameter keine oder allenfalls eine wenig aussagekräftige Bewertung umfasst. Beispielsweise kann bei Erreichen oder Unterschreiten einer unteren Spannungsschwelle durch die Batteriespannung eine Warnung über einen problematischen Ladezustand der Batterie ausgegeben werden.

In einer Ausgestaltung weist das Erfassungsmodul einen Spannungsmesser auf und die durch das Erfassungsmodul erfasste Messgröße ist durch eine an dem Energieversorgungseingang anliegende Versorgungsspannung gebildet, wobei die anliegende Versorgungsspannung durch den Spannungsmesser erfassbar ist. Auf diese Weise kann eine Vorrichtung entstehen, die eine anliegende Versorgungsspannung überwachen kann. Diese Ausgestaltung ist in den Fällen von besonders hohem Wert, in dem eine Fahrzeugbatterie (oder mehrere Fahrzeugbatterien) bewertet werden soll. Da eine Batteriespannung von dem Ladezustand der Batterie abhängig ist, kann durch Bewerten der Batteriespannung auf den Ladezustand der Batterie geschlossen und ein problematischer Entladezustand erkannt werden. Damit kann diese Ausgestaltung als Batterieüberwachungssystem genutzt werden.

In einer Weiterbildung umfasst der Spannungsmesser einen Stromspiegel, wobei der Stromspiegel die anliegende Versorgungsspannung in einen Stromfluss wandelt und vorzugsweise eine Transformation des Stromflusses in einen Messbereich des Erfassungsmoduls vornimmt. Ein Stromspiegel kann einen Referenzstrom "kopieren" und/oder skalieren. Bei dieser Ausgestaltung würde also zunächst eine anliegende Versorgungsspannung in einen Stromfluss gewandelt und dieser Stromfluss als Referenzstrom genutzt. Der Ausgangsstrom kann auf diese Weise in gewünschter Art angepasst werden. In einer Ausgestaltung kann damit eine Messbereichsanpassung vorgenommen werden und der in den Stromspiegel eingegebene Stromfluss in einen Messbereich des Erfassungsmoduls transformiert werden.

In einer Weiterbildung ist das Erfassungsmodul ergänzend dazu ausgebildet, eine erfasste Versorgungsspannung mit mindestens einem Spannungsgrenzwert zu vergleichen und basierend auf einem Vergleichsergebnis den ermittelten Parameter zu ermitteln, wobei der ermittelte Parameter vorzugsweise angibt, ob eine Versorgungsspannung in einem günstigen Bereich, eine Versorgungsspannung in einem ungünstigen Bereich und/oder eine Versorgungsspannung in einem kritischen Bereich liegt. Auf diese Weise gibt der ermittelte Parameter unmittelbar eine Bewertung der anliegenden und erfassten Versorgungsspannung an. Dabei kann der Parameter beispielsweise drei Werte annehmen: Einen ersten Wert, der auf einen guten oder zumindest ausreichend guten Ladezustand schließen lässt, einen zweiten Wert, der einen reduzierten, aber (noch) nicht kritischen Ladezustand angibt, und einen dritten Wert, der einen problematischen niedrigen Ladezustand kennzeichnet. Ein derartiger Parameter erlaubt auf einfache Art und Weise, den Ladezustand der Fahrzeugbatterie zu erkennen und zu bewerten.

In einer Ausgestaltung ist die durch das Erfassungsmodul erfasste Messgröße durch Positionssignale eines vorzugsweise satellitengestützten Positionsbestimmungssystems und der ermittelte Parameter durch eine geografische Position der Vorrichtung gebildet. Diese Ausgestaltung erlaubt, die Position des Fahrzeugs zu ermitteln und zu überwachen und an eine zentrale Stelle (beispielsweise einem Cloud-System) zu kommunizieren. Diese Ausgestaltung ist beispielsweise bei Schienenfahrzeugen interessant, die in einem großen geografischen Gebiet, beispielsweise in der gesamten Europäischen Union, zum Einsatz kommen und erlaubt das Schienenfahrzeug ohne großen Aufwand auffinden zu können. Das Positionsbestimmungssystem kann unterschiedlich aufgebaut sein. Wegen der universellen Einsetzbarkeit bieten sich aber insbesondere satellitengestützte System an, beispielsweise GPS (Global Positioning System) oder Galileo. Abhängig von dem verwendeten Positionsbestimmungssystem sind auch die Positionssignale ausgebildet. Meist sind für die Gewinnung des Positionssignals dedizierte Antennen und/oder Auswerteeinheiten erforderlich. Diese können vollständig oder teilweise in dem Erfassungsmodul integriert sein. Alternativ können sie als zusätzliche Komponenten (als Teil des Primärmoduls oder außerhalb des Primärmoduls, beispielsweise im Sekundärmodul) ausgebildet sein, wodurch das Erfassungsmodul für das Erfassen eines Positionssignals anstößt.

In einer Ausgestaltung weist das Erfassungsmodul einen Temperatursensor auf oder dem Erfassungsmodul ist ein Temperatursensor zugeordnet und die durch das Erfassungsmodul erfasste Messgröße ist durch eine Temperatur gebildet. Dadurch kann die Vorrichtung überwachen, bei welcher Temperatur die Vorrichtung betrieben wird und ob eventuell problematische Temperaturen vorliegen. Der Temperatursensor kann auf unterschiedliche Weise gebildet sein. Vorzugsweise kommt ein Heiß- oder Kaltleiter zum Einsatz, d.h. ein Widerstand, dessen Widerstandswert sich in Abhängigkeit der Temperatur definiert ändert. Besonders bevorzugter Weise kommt ein Platin-basierter Temperatursensor zum Einsatz, beispielsweise ein Pt100.

In einer Ausgestaltung weist das Primärmodul einen Speicher auf, der dazu ausgebildet ist, vorzugsweise unabhängig von einem Betriebszustand des Sekundärmoduls erfasste Messgrößen und/oder ermittelte Parameter abzuspeichern und/oder für eine spätere Verwendung bereitzuhalten. Auf diese Weise können Messgrößen und/oder Parameter auch dann erfasst werden, wenn eine direkte Verarbeitung nicht möglich oder unerwünscht ist. Dies kann beispielsweise dann hilfreich sein, wenn sich ein für ein Versenden einer Signalisierung eingesetztes Sekundärmodul in einem Ruhezustand befindet und ein Aktivieren dieses Sekundärmoduls derzeit nicht möglich oder nicht gewünscht ist. Der Speicher kann auf verschiedene Weise ausgebildet sein. Ein flüchtiger Speicher ist ebenso einsetzbar wie ein nichtflüchtiger Speicher. Lediglich beispielhaft sei auf RAM (Random Access Memory), MRAM (Magnetoresistive Random Access Memory) oder Flash-Speicher verwiesen. Bei Verwendung eines RAM kann dessen Speicherinhalt über ein Pufferelement, beispielsweise einen Gold Cap (oder einen sonstigen Kondensator) oder einen Akkumulator, abgesichert sein.

In einer Ausgestaltung weist das Sekundärmodul ein Netzteil auf, das durch eine in den Energieversorgungseingang des Primärmoduls eingegebene Versorgungsspannung mit Energie versorgbar ist und zur Versorgung des Sekundärmoduls und/oder mindestens eines Peripheriegeräts ausgebildet ist, wobei die Aktivierungsschaltung vorzugsweise eine Schalteinrichtung aufweist, die zum Schalten der eingegebenen Versorgungsspannung an das Netzteil ausgebildet ist. Auf diese Weise kann ein besonders effektives Energiemanagement verwirklicht werden, da sich das Sekundärmodul und/oder das mindestens eine Peripheriegerät durch Deaktivieren des Netzteils vollständig abschalten lässt. Dabei kann das Netzteil einen großen Eingangsspannungsbereich aufweisen, beispielsweise zwischen 24 V und 110 V. Ferner kann das Netzteil - insbesondere für den Einsatz der Vorrichtung bei Schienenfahrzeugen - für den Bahneinsatz zertifiziert und/oder ohne zusätzliche Komponenten (wie Leistungsschutzschalter, Koppelrelais, etc.) betreibbar sein. Derartige Netzteile werden beispielsweise durch die intreXis AG (Neuhausen am Rheinfall, Schweiz) hergestellt und vertrieben. Da Netzteile beim Anschalten Stromspitzen hervorrufen, bietet es sich an, dass eine Eingangsstrombegrenzung vorhanden ist. Hierzu könnte ein Messshunt verwendet werden. Denkbar ist auch, die Eingangsstrombegrenzung durch einen Heißleiter zu bewerkstelligen, dessen Widerstand bei hohen Strömen ansteigt und damit eine Strombegrenzung erreicht. Die Schalteinrichtung kann ebenfalls verschiedentlich ausgebildet sein, wobei es sich anbietet, wenn die Schalteinrichtung mit einem niedrigen Energieaufwand geschaltet werden kann, eine hohe Anzahl von Schaltzyklen erlaubt und im geschalteten Zustand einen möglichst niedrigen Durchgangswiderstand aufweist. Hier bietet sich beispielsweise ein MOSFET (Metal Oxide Semiconductor Field Effect Transistor) an.

In einer Ausgestaltung sind das Primärmodul und das Sekundärmodul galvanisch voneinander getrennt und/oder weisen gegeneinander eine Isolationsfestigkeit auf, wobei die Isolationsfestigkeit vorzugsweise größer oder gleich 1 Kilovolt ist. Auf diese Weise lässt sich die Betriebssicherheit der Vorrichtung erhöhen, insbesondere, wenn die Vorrichtung in einem Schienenfahrzeug zum Einsatz kommt.

In einer Ausgestaltung weist die Vorrichtung zusätzlich ein Schnittstellenmodul auf, das eine Kommunikation mit mindestens einem Peripheriegerät ermöglicht, wobei das Schnittstellenmodul vorzugsweise für eine Teilnahme in einem Bus, besonders bevorzugter Weise einem CAN-Bus - Controller Area Network Bus - und/oder einem MVB - Multifunctional Vehicle Bus - ausgebildet ist. Auf diese Weise kann die Vorrichtung Peripheriegeräte ansprechen und bereits am Markt befindliche Geräte lassen sich integrieren. Damit kann eine Steuerbarkeit durch das Primärmodul bis zu den Peripheriegeräten erweitert werden.

In einer Ausgestaltung kommt die Vorrichtung der vorliegenden Offenbarung zusammen mit mindestens einer Datenquelle und/oder mindestens einer Datensenke in einem System zum Einsatz. Dabei kann die mindestens eine Datenquelle / mindestens eine Datensenke einen Datenlogger, ein Datenspeichergerät, ein Kommunikationsgerät für ein Weitbereichsnetzwerk, einen Sensor, ein Ein-/Ausgabegerät zum Ansteuern eines Sensors, einen Empfänger für Signale aus einem Positionsbestimmungssystem, ein Steuergerät und/oder sonstige Geräte zum Erzeugen und/oder Verarbeiten von Daten umfassen. Auf diese Weise kann die Funktionalität der Vorrichtung noch weiter gesteigert werden.

In einer Ausgestaltung des Systems ist die mindestens eine Datensenke mit dem Signalisierungsausgang der Vorrichtung kommunizierend verbunden und zum Empfangen einer Signalisierung aus dem Signalisierungsausgang ausgebildet. Damit kann besonders universell mit einer Signalisierung umgegangen werden. So kann eine Datensenke durch ein Kommunikationsgerät für ein Weitbereichsnetzwerk gebildet sein, das eine erhaltene Signalisierung an ein Cloud-System überträgt.

In einer Ausgestaltung des Systems ist die mindestens eine Datenquelle / Datensenke mit einem Schnittstellenmodul der Vorrichtung kommunizierend verbunden und sendet Daten in das Schnittstellenmodul oder empfängt Daten von dem Schnittstellenmodul. Diese Ausgestaltung ermöglicht das Nutzen von in Fahrzeugen üblichen Schnittstellen, beispielsweise einen CAN-Bus oder einen MVB. Entsprechend würde das Schnittstellenmodul eine Teilnahme an diesem Bus ermöglichen.

Es gibt nun verschiedene Möglichkeiten, die Lehre der vorliegenden Erfindung in vorteilhafter Weise auszugestalten und weiterzubilden. Dazu ist einerseits auf die den nebengeordneten Ansprüchen nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: ein Blockschaltbild eines Ausführungsbeispiels einer Vorrichtung gemäß der vorliegenden Offenbarung,
- Fig. 2: ein Schaltbild mit Funktionsblöcken eines weiteren Ausführungsbeispiels einer Vorrichtung gemäß der vorliegenden Offenbarung und
- Fig. 3: ein Diagramm mit einem Verlauf einer Versorgungsspannung, die sich abhängig von einem Ladezustand einer Batterie ändert.

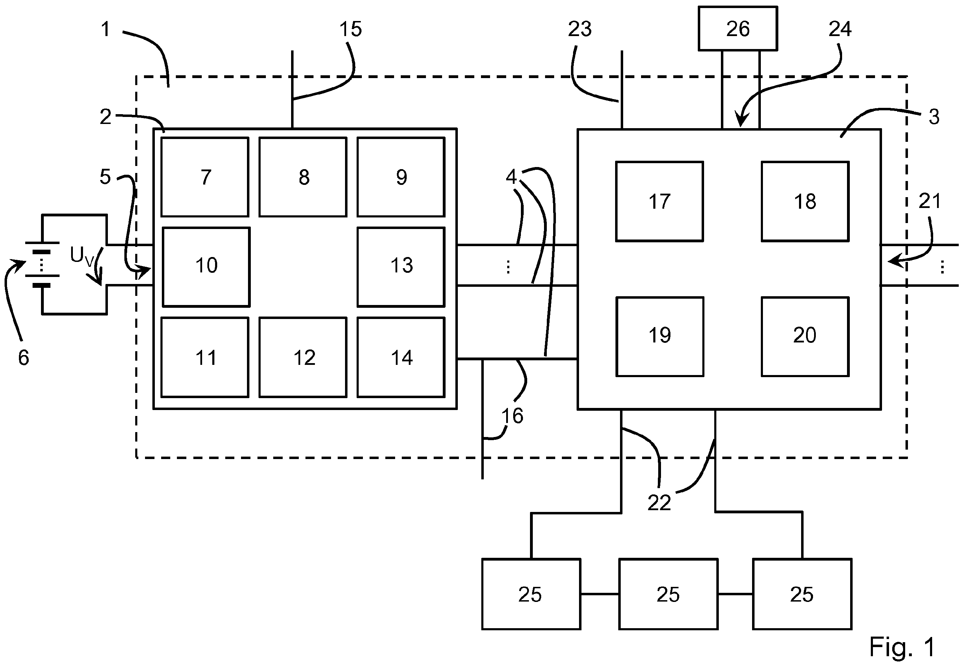

Fig. 1 zeigt ein Blockschaltbild eines Ausführungsbeispiels einer Vorrichtung gemäß der vorliegenden Offenbarung. Die Vorrichtung 1 umfasst ein Primärmodul 2 und ein Sekundärmodul 3, die untereinander mit mehreren Schnittstellen 4 verbunden sind. Das Primärmodul 2 weist einen Energieversorgungseingang 5 auf, der mit einer Reihenschaltung von Batterien - nachfolgend gemeinsam als Batterie 6 bezeichnet - verbunden ist und an dem eine durch die Batterie 6 bereitgestellte Versorgungsspannung Uv anliegt.

Das Primärmodul 2 weist eine Spannungsstabilisierung 7, eine Triggereinheit 8, eine Aktivierungsschaltung 9, einen oder mehrere Sensoren 10, ein Erfassungsmodul 11, eine Bewertungseinheit 12, einen Timer 13 und einen Speicher 14 auf. Ferner weist das Primärmodul 2 einen Triggereingang 15 auf, der mit einem KL15-Anschluss des Fahrzeuges verbunden und zum Eingeben eines Zündsignals ausgebildet ist.

Die an dem Energieversorgungseingang 5 anliegende Versorgungsspannung Uv wird in die Spannungsstabilisierung 7 eingegeben, die eine stabile Energieversorgung für die Komponenten des Primärmoduls 2 und gegebenenfalls von Teilen des Sekundärmoduls 3 bereitstellt. Die Triggereinheit 8 kann Triggerereignisse von dem Timer 13 und/oder dem Triggereingang 15 empfangen und basierend auf einem empfangenen Triggerereignis eine Aktion in dem Primärmodul 2 auslösen. Eine Aktion kann beispielsweise das Erfassen einer Messgröße, das Ermitteln eines Parameters, das Aktivieren des Sekundärmoduls 3, das Aktivieren eines Peripheriegeräts 25 oder dergleichen umfassen. Die Aktivierungsschaltung 9 ist dazu ausgebildet, das Sekundärmodul 3 zu aktivieren und/oder zu steuern. Hierzu kann die Aktivierungsschaltung 9 eine Schalteinrichtung 28 umfassen, die beispielsweise eine an dem Energieversorgungseingang 5 anliegende Versorgungsspannung Uv an eine der Schnittstellen 4 aufschaltet. In diesem Fall ist eine der Schnittstellen 4 durch eine Energieversorgungsleitung gebildet.

Das Erfassungsmodul 11 ist mit dem Sensor 10 verbunden. Der Sensor 10 erfasst eine Messgröße, beispielsweise die Temperatur des Primärmoduls 2 oder eine am Energieversorgungseingang 5 anliegende Versorgungsspannung Uv, und wird dabei durch das Erfassungsmodul 11 an-/gesteuert. Das Erfassungsmodul 11 kann zudem basierend auf einer erfassten Messgröße einen Parameter ermitteln. In dem Erfassungsmodul 11 kann ein Analog-Digital-Wandler integriert sein. Die Bewertungseinheit 12 ist dazu ausgebildet, eine erfasste Messgröße und/oder einen ermittelten Parameter zu bewerten. Der Speicher 14 kann einen flüchtigen Speicher, beispielsweise RAM, oder nicht-flüchtigen Speicher, beispielsweise Flash-Speicher, umfassen, und der Zwischenspeicherung von erfassten Messgrößen und/oder ermittelten Parametern dienen. Dabei kann es sich anbieten, wenn jede abgespeicherte Größe zusammen mit einem Zeitstempel abgespeichert wird, damit die abgespeicherte Größe später in einen zeitlichen Kontext gestellt werden kann.

Eine der Schnittstellen 4 zwischen Primärmodul 2 und Sekundärmodul 3 ist als Signalisierungsausgang 16 ausgebildet, über den das Primärmodul 2 eine Signalisierung ausgegeben kann. Hierzu kann eine Komponente des Primärmoduls 2, beispielsweise das Erfassungsmodul 11 oder die Bewertungseinheit 12, zum Erzeugen und Ausgeben einer Signalisierung ausgebildet sein, wobei die Signalisierung auf dem ermittelten Parameter und damit auf der erfassten Messgröße basiert.

Das Sekundärmodul 3 umfasst ein Netzteil 17, Speicher 18, ein Schnittstellenmodul 19, einen Mikroprozessor 20, einen Spannungsversorgungsausgang 21, einen Bus-Anschluss 22, eine Konfigurationsschnittstelle 23 und einen Messeingang 24. Das Netzteil 17 kann eine Versorgungsspannung erzeugen und an dem Spannungsversorgungsausgang 21 ausgeben. Hierzu ist ein Eingang des Netzteils 17 über eine der Schnittstellen 4 und die Aktivierungsschaltung 9 mit dem Energieversorgungseingang 5 verbunden. Auf diese Weise kann eine durch die Batterie 6 bereitgestellte Versorgungsspannung Uv über die Aktivierungsschaltung 9 aktiviert und auf das Netzteil 17 geschaltet werden. Die durch das Netzteil 17 ausgegebene Spannung, beispielsweise 24 V, kann zur Versorgung des Sekundärmoduls 3 und/oder von Peripheriegeräten 25 genutzt werden. Der Spannungsversorgungsausgang 21 kann mehrpolig ausgeführt sein, d.h. die ausgegebene Spannung kann an mehreren Ausgangspolen anliegen.

Der Speicher 18 kann durch den Mikroprozessor 20 genutzt werden und kann flüchtigen Speicher, beispielsweise RAM, und nicht-flüchtigen Speicher, beispielsweise Flash-Speicher, umfassen. Der Mikroprozessor 20 wird zur Durchführung von Aufgaben des Sekundärmoduls genutzt.

Das Schnittstellenmodul 19 ist dazu ausgebildet, eine Teilnahme an einem Bus zu ermöglichen. Hierzu ist das Schnittstellenmodul 19 mit einem Bus-Anschluss 22 verbunden, an dem wiederum mehrere Peripheriegeräte 25 angeschlossen sein können. An dem Bus-Anschluss 22 kann auch eine durch das Netzteil 17 ausgegebene Spannung anliegen. Der Bus kann beispielsweise als CAN-Bus ausgebildet sein. Die Peripheriegeräte 25 können Datensenken und/oder Datenquellen sein und beispielsweise Schnittstelleneinheiten zum Anschluss eines Sensors, Kommunikationseinheiten zur Kommunikation über ein Weitbereichsnetzwerk, einen Datenlogger oder einen GPS-Empfänger umfassen, um lediglich einige mögliche Peripheriegeräte beispielhaft zu nennen. Hierzu kann auch der Signalisierungsausgang 16 mit einem der Peripheriegeräte 25 verbunden sein.

Die Konfigurationsschnittstelle 23 kann zur Konfiguration des Sekundärmoduls genutzt werden und kann beispielsweise durch USB - Universal Serial Bus - bereitgestellt werden. Über diese Schnittstelle können auch Updates und/oder zusätzliche Softwaremodule einspielbar sein. Mit dem Messeingang 24 kann ein externer Sensor 26 verbunden sein. Der externe Sensor 26 kann beispielsweise ein Temperatursensor sein.

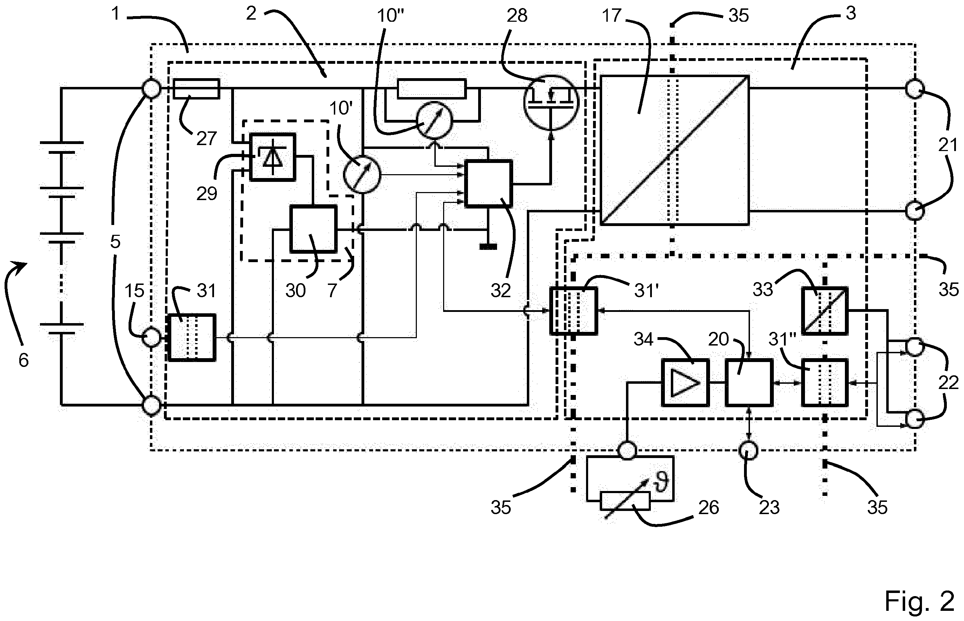

Fig. 2 zeigt eine schaltungstechnischere Darstellung einer derartigen Vorrichtung, wobei Funktionseinheiten mit identischen Funktionen in den Figuren 1 und 2 mit identischen Bezugszeichen bezeichnet sind. Die Vorrichtung 1 umfasst wiederum ein Primärmodul 2 und ein Sekundärmodul 3. Eine Batterie 6 ist mit dem Energieversorgungseingang 5 verbunden. Der Pluspol der Batterie 6 ist über eine Sicherung 27 abgesichert. Die dort anliegende Spannung wird zum einen in eine Spannungsstabilisierung 7, zum anderen ein MOSFET 28 eingegeben. Zudem misst ein Spannungssensor 10' die anliegende Spannung und ein Stromsensor 10" den fließenden Strom. Die Spannungsstabilisierung 7 umfasst eine Spannungsreferenz 29 und einen Spannungsregler 30. Der MOSFET 28 fungiert hier als Aktivierungsschaltung 9 und kann die anliegende Versorgungsspannung Uv auf das Netzteil 17 schalten. Ein Isolierglied 31, beispielsweise in Form eines Optokopplers, dient der Isolierung des Triggereingangs 15 für einen KL15-Anschluss. Ein Mikrocontroller 32 implementiert verschiedene Funktionsblöcke der Fig. 1, beispielsweise das Erfassungsmodul 11, die Triggereinheit 8 oder die Bewertungseinheit 12.

Eine zentrale Einheit des Sekundärmoduls 3 ist der Mikroprozessor 20, der viele Funktionen des Sekundärmoduls 3 implementieren kann. Ein Isolierglied 31' wird zur Kommunikation zwischen Primärmodul 2 und Sekundärmodul 3 genutzt. Ein Isolierglied 31" dient der Kommunikation über den Bus-Anschluss 22. An dem Bus-Anschluss 22 wird auch eine Versorgungsspannung über eine isolierte Spannungsversorgung 33 bereitgestellt. Die isolierte Spannungsversorgung 33 kann aus dem Netzteil 17 mit Energie versorgt werden. Ein Messverstärker 34 dient der Verstärkung eines Messsignals des externen Sensors 26, hier ein Temperatursensor, wobei Messverstärker 34 und externer Sensor 26 in Dreileiter- oder Vierleitertechnik miteinander verbunden sein können. In Fig. 2 sind ferner mit dicken gestrichelten Linien Isolierstrecken 35 zwischen einzelnen Bestandteilen der Vorrichtung 1 verdeutlicht. Dabei bewirken die Isolierstrecken 35 eine Isolierfestigkeit von bis zu 1700 V.

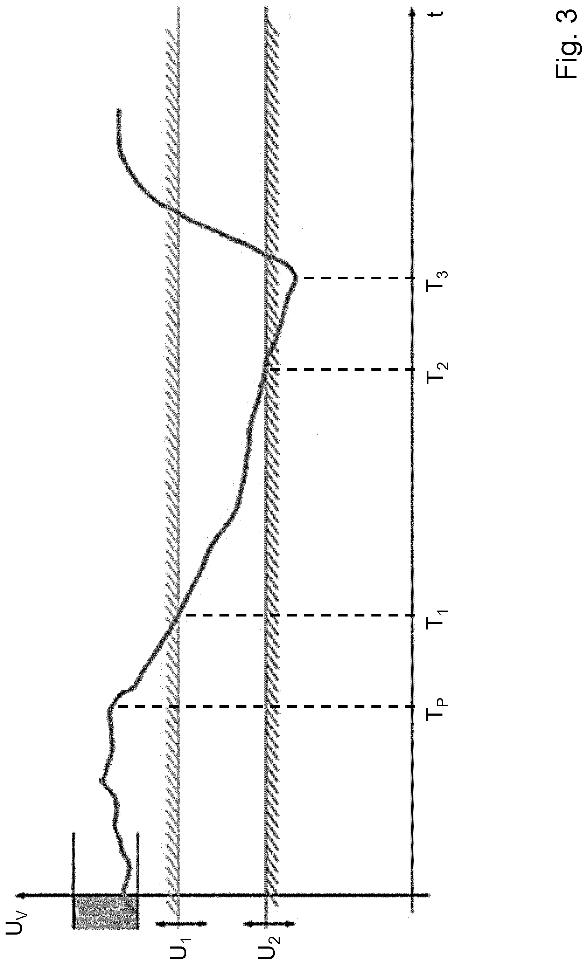

Fig. 3 zeigt ein Diagramm mit einem beispielhaften Verlauf einer Versorgungsspannung Uv an dem Energieversorgungseingang 5 über der Zeit t. Zu Beginn des dargestellten Verlaufs ist das Fahrzeug mit einer Energiequelle verbunden, beispielsweise einem Energieversorgungsnetzwerk oder einem mit Verbrennungsmotor angetriebenen Generator. In dieser Zeit wird die Batterie 6 des Fahrzeugs geladen oder der Ladezustand der Batterie 6 weitgehend aufrechterhalten.

Zum Zeitpunkt Tp wird das Fahrzeug geparkt und in einen abgerüsteten Zustand versetzt. Durch weiterhin verbundene Lasten und Entladevorgänge innerhalb der Batterie 6 nimmt der Ladezustand der Batterie 6 nach und nach ab, was sich in einer sinkenden Klemmenspannung und damit einer sinkenden Versorgungsspannung Uv auswirkt. Solange die Versorgungsspannung Uv oberhalb einer ersten Spannungsschwelle U₁ liegt, könnte die Vorrichtung 1 weiterhin uneingeschränkt betrieben werden. In diesem Zustand könnte das Primärmodul voll aktiv bleiben und beispielsweise im Sekundentakt Messgrößen erfassen und bewerten.

Zum Zeitpunkt T₁ unterschreitet die Versorgungsspannung Uv die erste Spannungsschwelle U₁. Danach bietet es sich an, dass die Vorrichtung 1 noch sparsamer mit der verfügbaren Energie umgeht. Dies kann dadurch erreicht werden, dass das Primärmodul so weit wie möglich einen Energiesparmodus aktiviert und/oder die zeitlichen Abstände zwischen Messungen und Bewertungen größer wählt, beispielsweise nicht mehr im Sekundentakt sondern im Minutentakt. Ein Prototyp einer derartigen Vorrichtung 1 zieht im Energiesparmodus einen Strom von weniger als 1 Milliampere. Da das Erfassen und Bewerten von Messgrößen jeweils lediglich einige Mikrosekunden in Anspruch nehmen, kann auf diese Weise ein stark reduzierter Energieverbrauch realisiert werden. Ferner kann die Vorrichtung nach Unterschreiten der ersten Spannungsschwelle U₁ Warnmeldungen absetzen, die über das Unterschreiten der ersten Spannungsschwelle U₁ informiert. Diese Warnmeldung kann beispielsweise durch ein Cloudsystem empfangen und einer Überwachungszentrale zur Verfügung gestellt werden.

Zum Zeitpunkt T₂ wird eine zweite Spannungsschwelle U₂ unterschritten. Damit hat der Ladezustand einen problematischen Wert erreicht und die weitere Entladung der Batterie 6 sollte möglichst vermieden werden. Bei Erkennen eines Unterschreitens der zweiten Spannungsschwelle U₂ kann die Vorrichtung 1 über den Signalisierungsausgang 16 eine Alarmmeldung absetzen, die beispielsweise über den kritischen Ladezustand sowie den Standort des Fahrzeugs informiert. Nach Absetzen der Alarmmeldung (und eventuellem Empfang einer Quittierung durch ein empfangendes System) kann sich die Vorrichtung 1 abschalten, um eine weitere Entladung der Batterie 6 zu vermeiden. Dabei ist es auch denkbar, dass ein Timer 13 die Vorrichtung kurz aufweckt, um beispielsweise stündlich den Zustand zu prüfen.

Unabhängig von der deaktivierten Vorrichtung wird die Batterie 6 weiter entladen. Zum Zeitpunkt T₃ wird die Batterie 6 mit einer Energieversorgung verbunden, beispielsweise einem Energieversorgungsnetzwerk. Danach wird die Batterie 6 wieder aufgeladen. Die Vorrichtung 1 kann durch Empfangen eines Zündimpulses (beispielsweise eine positive Flanke am Triggereingang 15) wieder aktiviert werden.

Hinsichtlich weiterer vorteilhafter Ausgestaltungen wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Vorrichtung
- 2: Primärmodul
- 3: Sekundärmodul
- 4: Schnittstellen
- 5: Energieversorgungseingang
- 6: Batterie
- 7: Spannungsstabilisierung
- 8: Triggereinheit
- 9: Aktivierungsschaltung
- 10: Sensor
- 11: Erfassungsmodul
- 12: Bewertungseinheit
- 13: Timer
- 14: Speicher
- 15: Triggereingang
- 16: Signalisierungsausgang
- 17: Netzteil
- 18: Speicher
- 19: Schnittstellenmodul
- 20: Mikroprozessor
- 21: Spannungsversorgungsausgang
- 22: Bus-Anschluss
- 23: Konfigurationsschnittstelle
- 24: Messeingang
- 25: Peripheriegeräte
- 26: Externer Sensor
- 27: Sicherung
- 28: Schalteinrichtung
- 29: Spannungsreferenz
- 30: Spannungsregler
- 31: Isolierglied
- 32: Mikrocontroller
- 33: Isolierte Spannungsversorgung
- 34: Messverstärker
- 35: Isolierstrecke

## Patentansprüche

1. Vorrichtung zum Überwachen eines Parameters eines Fahrzeugs, vorzugsweise eines Schienenfahrzeugs, umfassend ein Primärmodul (2) und ein Sekundärmodul (3), wobei das Sekundärmodul (3) über mindestens eine Schnittstelle (4) mit dem Primärmodul (2) verbunden und durch das Primärmodul (2) zumindest teilweise steuerbar ist, wobei das Primärmodul (2) umfasst:
einen Energieversorgungseingang (5), der zum Eingeben einer Versorgungsspannung (Uv) aus einer Energieversorgung (6) des Fahrzeugs in das Primärmodul (2) ausgebildet ist,
ein Erfassungsmodul (11), das zum Erfassen mindestens einer Messgröße und zum Ermitteln eines ermittelten Parameters bezüglich des Fahrzeugs aus der mindestens einen Messgröße ausgebildet ist,
eine Aktivierungsschaltung (9), die dazu ausgebildet ist, unter Nutzung des ermittelten Parameters das Sekundärmodul (3) zu aktivieren und/oder zu steuern, und
einen Signalisierungsausgang (16), der dazu ausgebildet ist, basierend auf dem ermittelten Parameter eine Signalisierung zu erzeugen und/oder auszugeben.

2. Vorrichtung nach Anspruch 1, **dadurch gekennzeichnet, dass** das Primärmodul (2) eine Triggereinheit (8) aufweist, wobei die Triggereinheit (8) dazu ausgebildet ist, basierend auf einem Triggerereignis das Primärmodul (2) vorzugsweise unabhängig von einem aktuellen Betriebsmodus der Vorrichtung (1) zum Erfassen der mindestens einen Messgröße und/oder zum Ermitteln des ermittelten Parameters und/oder zum Erzeugen einer Signalisierung und/oder zum Ausgeben einer Signalisierung zu veranlassen.

3. Vorrichtung nach Anspruch 2, zusätzlich umfassend einen Timer (13) und/oder einen Triggereingang (15) und/oder eine Bewertungseinheit (12), die dazu ausgebildet sind, ein Triggerereignis für die Triggereinheit (8) zu erzeugen, wobei der Triggereingang (15) vorzugsweise zum Eingeben eines Zündsignals des Fahrzeugs ausgebildet ist und wobei die Bewertungseinheit (12) vorzugsweise zum Bewerten eines ermittelten Parameters ausgebildet ist.

4. Vorrichtung nach einem der Ansprüche 1 bis 3, **dadurch gekennzeichnet, dass** das Erfassungsmodul (11) einen Spannungsmesser (10') aufweist und die durch das Erfassungsmodul (11) erfasste Messgröße durch eine an dem Energieversorgungseingang (5) anliegende Versorgungsspannung (Uv) gebildet ist, wobei die anliegende Versorgungsspannung (Uv) durch den Spannungsmesser (10') erfassbar ist.

5. Vorrichtung nach Anspruch 4, **dadurch gekennzeichnet, dass** der Spannungsmesser (10') einen Stromspiegel umfasst, wobei der Stromspiegel die anliegende Versorgungsspannung (Uv) in einen Stromfluss wandelt und vorzugsweise eine Transformation des Stromflusses in einen Messbereich des Erfassungsmoduls (11) vornimmt.

6. Vorrichtung nach Anspruch 4 oder 5, **dadurch gekennzeichnet, dass** das Erfassungsmodul (11) ergänzend dazu ausgebildet ist, eine erfasste Versorgungsspannung (Uv) mit mindestens einem Spannungsgrenzwert (U₁, U₂) zu vergleichen und basierend auf einem Vergleichsergebnis den ermittelten Parameter zu ermitteln, wobei der ermittelte Parameter vorzugsweise angibt, ob eine Versorgungsspannung (Uv) in einem günstigen Bereich, eine Versorgungsspannung in einem ungünstigen Bereich und/oder eine Versorgungsspannung in einem kritischen Bereich liegt.

7. Vorrichtung nach einem der Ansprüche 1 bis 6, **dadurch gekennzeichnet, dass** die durch das Erfassungsmodul (11) erfasste Messgröße durch Positionssignale eines vorzugsweise satellitengestützten Positionsbestimmungssystems gebildet ist und dass der ermittelte Parameter durch eine geografische Position der Vorrichtung gebildet ist und/oder
dass das Erfassungsmodul (11) einen Temperatursensor aufweist oder das Erfassungsmodul (11) ein Temperatursensor zugeordnet ist und dass die durch das Erfassungsmodul (11) erfasste Messgröße durch eine Temperatur gebildet ist.

8. Vorrichtung nach einem der Ansprüche 1 bis 7, **dadurch gekennzeichnet, dass** das Primärmodul (2) einen Speicher (14) aufweist und dass der Speicher (14) dazu ausgebildet ist, unabhängig von einem Betriebszustand des Sekundärmoduls (3) erfasste Messgrößen und/oder ermittelte Parameter abzuspeichern und/oder für eine spätere Verwendung bereitzuhalten.

9. Vorrichtung nach einem der Ansprüche 1 bis 8, **dadurch gekennzeichnet, dass** das Sekundärmodul (3) ein Netzteil (17) aufweist, das durch eine in den Energieversorgungseingang (5) des Primärmoduls (2) eingegebene Versorgungsspannung (Uv) mit Energie versorgbar ist und zur Versorgung des Sekundärmoduls (3) und/oder mindestens eines Peripheriegeräts (25) ausgebildet ist, wobei die Aktivierungsschaltung (9) vorzugsweise eine Schalteinrichtung (28) aufweist, die zum Schalten der eingegebenen Versorgungsspannung (Uv) an das Netzteil (17) ausgebildet ist.

10. Vorrichtung nach einem der Ansprüche 1 bis 9, **dadurch gekennzeichnet, dass** das Primärmodul (2) und das Sekundärmodul (3) galvanisch voneinander getrennt sind und/oder gegeneinander eine Isolationsfestigkeit aufweisen, wobei die Isolationsfestigkeit vorzugsweise größer oder gleich 1 Kilovolt ist.

11. Vorrichtung nach einem der Ansprüche 1 bis 10, wobei die Vorrichtung (1) zusätzlich ein Schnittstellenmodul (19) aufweist, das eine Kommunikation mit mindestens einem Peripheriegerät (25) ermöglicht, wobei das Schnittstellenmodul (19) vorzugsweise für eine Teilnahme in einem Bus, besonders bevorzugter Weise einem CAN-Bus - Controller Area Network Bus - und/oder einem MVB - Multifunctional Vehicle Bus - ausgebildet ist.

12. System zum Überwachen eines Parameters eines Fahrzeugs, vorzugsweise eines Schienenfahrzeugs, umfassend:
eine Vorrichtung (1) nach einem der Ansprüche 1 bis 11 und
mindestens eine Datenquelle und/oder mindestens eine Datensenke,
wobei die mindestens eine Datenquelle / mindestens eine Datensenke vorzugsweise einen Datenlogger, ein Datenspeichergerät, ein Kommunikationsgerät für ein Weitbereichsnetzwerk, einen Sensor, ein Ein-/Ausgabegerät zum Ansteuern eines Sensors, einen Empfänger für Signale aus einem Positionsbestimmungssystem und/oder ein Steuergerät umfasst.

13. System nach Anspruch 12, **dadurch gekennzeichnet, dass** die mindestens eine Datensenke mit dem Signalisierungsausgang (16) der Vorrichtung (1) kommunizierend verbunden und zum Empfangen einer Signalisierung aus dem Signalisierungsausgang (16) ausgebildet ist, und/oder dass die mindestens eine Datenquelle / Datensenke mit einem Schnittstellenmodul (19) der Vorrichtung (1) kommunizierend verbunden ist und Daten in das Schnittstellenmodul (19) sendet oder von dem Schnittstellenmodul (19) empfängt.

14. Fahrzeug, vorzugsweise Schienenfahrzeug, umfassend eine Vorrichtung (1) nach einem der Ansprüche 1 bis 11 und/oder ein System nach Anspruch 12 oder 13, wobei das Fahrzeug eine Energieversorgung (6) umfasst, die mit dem Energieversorgungseingang (5) der Vorrichtung (1) verbunden ist.

15. Verfahren zum Überwachen eines Parameters eines Fahrzeugs, vorzugsweise eines Schienenfahrzeugs, wobei das Verfahren zur Verwendung mit einer Vorrichtung (1) nach einem der Ansprüche 1 bis 11 und/oder mit einem System nach Anspruch 12 oder 13 ausgebildet ist, umfassend:
Erfassen mindestens einer Messgröße, wobei die mindestens eine Messgröße eine physikalische Größe bezüglich des Fahrzeugs repräsentiert,
Ermitteln eines ermittelten Parameters bezüglich des Fahrzeugs basierend auf der mindestens einen Messgröße und
bedarfsgerechtes Aktivieren/Deaktivieren des Sekundärmoduls (3) der Vorrichtung (1) und/oder Erzeugen und/oder Ausgeben einer Signalisierung basierend auf dem ermittelten Parameter.
